# EUROPÄISCHE PATENTSCHRIFT

(11) **EP 3 900 186 B1**
(45) Veröffentlichungstag und Bekanntmachung des Hinweises auf die Patenterteilung: **10.09.2025**
(21) Anmeldenummer: 20706995.6
(22) Anmeldetag: 17.02.2020
(51) Int. Cl.: H03K 17/0812, H03K 17/60

(54) **SCHUTZ EINES HALBLEITERSCHALTERS**
PROTECTION OF A SEMICONDUCTOR SWITCH
PROTECTION D'UN COMMUTATEUR À SEMI-CONDUCTEUR

(30) Priorität: 18.03.2019 EP 19163391
(43) Veröffentlichungstag der Anmeldung: 27.10.2021
(73) Patentinhaber: Siemens Aktiengesellschaft, 80333 München (DE)
(72) Erfinder: STADTER, Norbert, 96155 Buttenheim (DE)
(74) Vertreter: Siemens Patent Attorneys
(86) Internationale Anmeldenummer: PCT/EP2020/054008
(87) Internationale Veröffentlichungsnummer: WO 2020/187510

(56) Entgegenhaltungen:
- DE-A1- 3 723 786
- US-A- 5 285 346
- US-A1- 2004 027 762
- US-A1- 2010 231 269
- TAKESHI HORIGUCHI ET AL: "A short circuit protection method based on a gate charge characteristic", 2014 INTERNATIONAL POWER ELECTRONICS CONFERENCE (IPEC-HIROSHIMA 2014, ECCE ASIA), 1 May 2014 (2014-05-01), pages 2290 - 2296, XP055616689, ISBN: 978-1-4799-2705-0, DOI: 10.1109/IPEC.2014.6869909

## Beschreibung

Die Erfindung betrifft eine Schutzschaltung für einen Halbleiterschalter mit einem durch einen Gate-Treiber ansteuerbaren Gate, eine Schaltungsanordnung mit einer derartigen Schutzschaltung und ein Verfahren zum Schutz eines Halbleiterschalters vor zu hohen Verlustleistungen.

Mit dem Gate eines Halbleiterschalters wird der Steueranschluss des Halbleiterschalters bezeichnet. Die Erfindung dient vornehmlich dem Schutz eines spannungsgesteuerten Halbleiterschalters, beispielsweise eines Bipolartransistors mit isolierter Gate-Elektrode (IGBT) oder eines Metall-Oxid-Halbleiter-Feldeffekttransistors (MOSFET), der über eine an das Gate gelegte Gate-Spannung beziehungsweise ein Gate-Potential angesteuert wird. Bei einer zu hohen Verlustleistung, beispielsweise im Falle eines Kurzschlusses, kann der Halbleiterschalter beschädigt oder zerstört werden. Zur Vermeidung solcher Schäden muss sichergestellt werden, dass, beispielsweise im Kurzschlussfall, die Gate-Spannung nicht deutlich über ihren spezifizierten Einschaltwert steigt (Einhaltung der so genannten "safe operating area"). Andernfalls kann der Anstieg der Gate-Spannung zu einem zu hohen Strom durch den Halbleiterschalter, beispielsweise einem zu hohen Kollektor-Strom im Fall eines IGBT beziehungsweise Drain-Strom im Fall eines MOSFET, führen und die Verlustleistung zu stark erhöhen.

Um eine Überhöhung der Verlustleistung zu verhindern, kann beispielsweise eine Spannung an einem Lastanschluss des Halbleiterschalters, beispielsweise die Kollektor-Spannung im Fall eines IGBT oder die Drain-Spannung im Fall eines MOSFET, mittels einer Hochspannungsdiode oder eines Operationsverstärkers erfasst und überwacht werden. Alternativ kann ein Strom durch den Halbleiterschalter, beispielsweise mit einem Shunt oder einem Stromwandler, erfasst und überwacht werden. Diese Methoden ermöglichen jedoch teilweise keine ausreichend schnelle Abschaltung des Halbleiterschalters, da Potentialhürden überschritten werden müssen, sind aufwändig und kostspielig und/oder haben wegen Luft- und Kriechstrecken einen hohen Platzbedarf.

US 2004/0027762 A1 offenbart einen Steuerkreis mit einem Gatespannungsdetektor, der eine Gate-Emitterspannung eines Leistungshalbleiterbauelements über einen Erfassungszeitraum erfasst. Der Steuerkreis erkennt das Auftreten einer Unregelmäßigkeit im Leistungshalbleiterbauelement, wenn die Gate-Emitterspannung einen Referenzwert überschreitet.

TAKESHI HORIGUCHI ET AL: "A short circuit protection method based on a gate charge characteristic", 2014 INTERNATIONAL POWER ELECTRONICS CONFERENCE (IPEC-HIROSHIMA 2014, ECCE ASIA), 1. Mai 2014 (2014-05-01), Seiten 2290-2296, XP055616689, DOI: 10.1109/IPEC.2014.6869909 ISBN: 978-1-4799-2705-0 beschreibt eine Hochgeschwindigkeitsschaltung zum Schutz von IGBTs gegen Kurzschlussfehler.

Aus der US 2010/231269 A1 ist eine Ansteuerschaltung bekannt, bei der verhindert wird, dass eine Abnormalität eines Halbleiterelements fälschlicherweise erfasst wird, wenn ein Gate-EIN-Befehl in einem Zustand eingetreten ist, in dem eine Gate-Spannung des Halbleiterelements nicht vollständig abgesenkt wurde. Ein Erfassungsprozess für eine Regelgröße des Halbleiterelements ist nur innerhalb eines Zeitraums zulässig, der einer Regelgröße des Halbleiterelements zu dem Zeitpunkt entspricht, zu dem ein "EIN" -Signal in eine Steuerschaltung eingegeben wurde, und einer erfassten Regelgröße, die wird innerhalb der Periode erfasst und eine Vergleichsregelgröße, die in Übereinstimmung mit der Regelgröße eingestellt ist, wird verglichen, um ein Abnormalitätssignal auszugeben, wobei das Halbleiterelement mit einer Geschwindigkeit abgeschaltet wird, die niedriger als beim normalen Ausschalten ist.

Der Erfindung liegt die Aufgabe zugrunde, einen Halbleiterschalter mit einem durch einen Gate-Treiber ansteuerbaren Gate vor zu hohen Verlustleistungen zu schützen.

Die Aufgabe wird erfindungsgemäß durch eine Schutzschaltung mit den Merkmalen des Anspruchs 1, eine Schaltungsanordnung mit den Merkmalen des Anspruchs 5, ein Verfahren mit den Merkmalen des Anspruchs 8 und ein Verfahren mit den Merkmalen des Anspruchs 9 gelöst.

Vorteilhafte Ausgestaltungen der Erfindung sind Gegenstand der Unteransprüche.

Eine erfindungsgemäße Schutzschaltung für einen Halbleiterschalter mit einem durch einen Gate-Treiber ansteuerbaren Gate umfasst einen Integrator zum Erfassen einer Gate-Ladung des Gate und eine Komparatoreinheit zum Abschalten des Halbleiterschalters in Abhängigkeit von dem Wert der Gate-Ladung relativ zu einer Referenzladung.

Die Erfindung nutzt aus, dass der Betriebszustand eines spannungsgesteuerten Halbleiterschalters (beispielsweise ein Sperrbetrieb, gesättigter Betrieb oder Linearbetrieb) anhand der Gate-Ladung des Gate des Halbleiterschalters ermittelt werden kann. Eine erfindungsgemäße Schutzschaltung weist daher einen Integrator zum Erfassen der Gate-Ladung auf. Ferner weist die Schutzschaltung eine Komparatoreinheit auf, mit der die Gate-Ladung mit einer Referenzladung verglichen wird. Die Referenzladung ist derart gewählt, dass eine Gate-Ladung mit dem Wert der Referenzladung einen kritischen Betriebszustand des Halbleiterschalters signalisiert. Daher ist die Komparatoreinheit dazu ausgebildet, den Halbleiterschalter in Abhängigkeit von dem Wert der Gate-Ladung relativ zu einer Referenzladung abzuschalten - beispielsweise den Halbleiterschalter abzuschalten, wenn die Gate-Ladung den Wert der Referenzladung erreicht beziehungsweise unterschreitet. Eine erfindungsgemäße Schutzschaltung ermöglicht daher die Überwachung des Betriebszustands eines Halbleiterschalters und eine Abschaltung des Halbleiterschalters, wenn der von der Gate-Ladung signalisierte Betriebszustand dies erfordert.

Bei einer ersten Ausführung der Schutzschaltung ist die Referenzladung zeitunabhängig (statisch) und die Komparatoreinheit ist dazu ausgebildet, den Halbleiterschalter abzuschalten, wenn die Gate-Ladung die Referenzladung unterschreitet. Dabei weist die Schutzschaltung ein Zeitglied zum Einstellen einer Mindestzeitdauer (einer so genannten Ausblendzeit) zwischen einem Einschalten des Halbleiterschalters und dem Abschalten des Halbleiterschalters durch die Komparatoreinheit auf. Die Mindestzeitdauer ist derart gewählt, dass während der Mindestzeitdauer eine Gatekapazität und eine Millerkapazität des Halbleiterschalters nach einem Einschalten in einem Normalbetrieb des Halbleiterschalters zumindest annähernd vollständig, beispielsweise mindestens zu 90 %, umgeladen sind. Dies berücksichtigt, dass die Gate-Ladung nach einem Einschalten des Halbleiterschalters erst durch Umladen der Gate- und Millerkapazität des Halbleiterschalters aufgebaut werden muss bis eine Beurteilung des Betriebszustands des Halbleiterschalters durch einen Vergleich der Gate-Ladung mit einer statischen Referenzladung möglich wird.

Das Zeitglied weist beispielsweise einen Zeitglied-Widerstand, einen Zeitglied-Kondensator und eine Zeitglied-Diode auf. Dabei ist die Anode der Zeitglied-Diode mit einem ersten Pol des Zeitglied-Widerstands und einer ersten Elektrode des Zeitglied-Kondensators verbunden und ein Ausgang des Integrators ist mit der Kathode einer Ausgangsdiode verbunden, deren Anode mit der Anode der Zeitglied-Diode, dem ersten Pol des Zeitglied-Widerstands und der ersten Elektrode des Zeitglied-Kondensators verbunden ist. Die Mindestzeitdauer für ein Abschalten nach einem Einschalten des Halbleiterschalters wird hier durch den Widerstandswert des Zeitglied-Widerstands und die Kapazität des Zeitglied-Kondensators eingestellt. Diese Ausführung des Zeitglieds ist besonders kostengünstig, da lediglich ein Widerstand und ein Kondensator verwendet werden.

Zur Realisierung einer Schutzschaltung mit einer statischen Referenzladung weist die Komparatoreinheit einen npn-Bipolartransistor, einen pnp-Bipolartransistor, zwei Komparator-Dioden, einen Komparator-Kondensator und drei Komparator-Widerstände auf. Dabei ist der Kollektor des npn-Bipolartransistors mit der Basis des pnp-Bipolartransistors verbunden, der Kollektor des pnp-Bipolartransistors ist mit der Basis des npn-Bipolartransistors und der Anode einer ersten Komparator-Diode verbunden, der Komparator-Kondensator und ein erster Komparator-Widerstand sind jeweils parallel zu der Basis-Emitter-Strecke des pnp-Bipolartransistors geschaltet, der zweite Komparator-Widerstand ist parallel zu der Basis-Emitter-Strecke des npn-Bipolartransistors geschaltet, die Kathode der ersten Komparator-Diode ist mit der Anode der Ausgangsdiode verbunden, der Emitter des npn-Bipolartransistors ist mit der zweiten Elektrode des Zeitglied-Kondensators verbunden, der Emitter des pnp-Bipolartransistors ist über den dritten Komparator-Widerstand mit dem zweiten Pol des Zeitglied-Widerstands verbunden, und die Basis des pnp-Bipolartransistors ist mit der Kathode der zweiten Komparator-Diode verbunden. Bei dieser Ausführung der Komparatoreinheit sind der pnp-Bipolartransistor und der npn-Bipolartransistor zu einer Thyristorstruktur verschaltet, durch deren Zündung der Halbleiterschalter abgeschaltet wird. Die erste Komparator-Diode ist beispielsweise eine Z-Diode, deren Zenerspannung zum Zünden der Thyristorstruktur die Referenzladung definiert.

Bei einer anderen Ausführung, welche nicht zur Erfindung gehört, weist die Schutzschaltung eine Referenzladungsschaltung auf, durch die die Referenzladung nach einem Einschalten des Halbleiterschalters während einer Anstiegsdauer von Null auf einen Endwert erhöht wird, wobei die Komparatoreinheit dazu ausgebildet ist, den Halbleiterschalter abzuschalten, wenn die Gate-Ladung die Referenzladung unterschreitet. Die Anstiegsdauer ist beispielsweise derart gewählt, dass eine Gatekapazität und eine Millerkapazität des Halbleiterschalters nach dem Verstreichen der Anstiegsdauer nach einem Einschalten in einem Normalbetrieb des Halbleiterschalters zumindest annähernd vollständig, beispielsweise mindestens zu 90%, umgeladen sind.

Bei einer derartigen Schutzschaltung wird die Referenzladung also nicht statisch realisiert, sondern nach dem Einschalten des Halbleiterschalters allmählich auf einen Endwert erhöht. Dadurch braucht im Unterschied zu der Ausgestaltung mit einer statischen Referenzladung nach einem Einschalten des Halbleiterschalters keine Mindestzeit abgewartet zu werden, bis ein Vergleich Gate-Ladung mit der Referenzladung erfolgen kann. Dies ermöglicht insbesondere eine frühzeitige Erkennung eines Kurzschlusses und ein entsprechend frühzeitiges **Ab**schalten des Halbleiterschalters, beispielsweise innerhalb von 2 µs nach dem Einschalten des Halbleiterschalters.

Zur Realisierung einer Schutzschaltung mit einer derartigen dynamischen Referenzladung weist die Komparatoreinheit beispielsweise einen Komparator-Operationsverstärker und eine Komparator-Diode auf und die Referenzladungsschaltung weist beispielsweise einen Referenzladungskondensator, einen Referenzladungswiderstand und zwei Referenzladungsdioden auf. Dabei ist der positive Eingang des Komparator-Operationsverstärkers mit dem Ausgang des Integrators verbunden, der negative Eingang des Komparator-Operationsverstärkers ist mit einem ersten Pol des Referenzladungswiderstands, einer ersten Elektrode des Referenzladungskondensators und der Anode einer ersten Referenzladungsdiode verbunden, der Ausgang des Komparator-Operationsverstärkers ist mit der Kathode der Komparator-Diode verbunden, die Kathode der ersten Referenzladungsdiode ist mit der Kathode der zweiten Referenzladungsdiode verbunden, und die Anode der zweiten Referenzladungsdiode ist mit dem Eingang des Integrators verbunden. Bei dieser Ausgestaltung der Schutzschaltung wird die Referenzladung durch das Aufladen des Referenzladungskondensators dynamisch aufgebaut. Der Endwert der Referenzladung wird durch die Eigenschaften der Referenzladungsdioden definiert. Die Anstiegsdauer zum Aufbau der Referenzladung wird durch den Widerstandswert des Referenzladungswiderstands und die Kapazität des Referenzladungskondensators eingestellt. Der Komparator-Operationsverstärker ermöglicht einen Vergleich der Gate-Ladung mit der Referenzladung und ein Abschalten des Halbleiterschalters durch die Ausgangsspannung des Komparator-Operationsverstärkers über die Komparator-Diode.

Eine erfindungsgemäße Schaltungsanordnung umfasst einen Halbleiterschalter mit einem Gate, einen Gate-Treiber zum Ansteuern des Gate und eine erfindungsgemäße Schutzschaltung. Der Gate-Treiber weist eine durch eine Treiberspannung des Gate-Treibers steuerbare elektronische Schalteinheit auf, mit der das Gate zum Einschalten des Halbleiterschalters mit einem Einschaltpotential und zum Ausschalten des Halbleiterschalters mit einem Ausschaltpotential verbunden wird. Die Vorteile einer erfindungsgemäßen Schaltungsanordnung ergeben sich aus den oben bereits genannten Vorteilen einer erfindungsgemäßen Schutzschaltung.

Bei der oben genannten Ausführung der Schutzschaltung mit einer statischen Referenzladung ist der Emitter des npn-Bipolartransistors mit dem Ausschaltpotential verbunden, der zweite Pol des Zeitglied-Widerstands ist mit dem Einschaltpotential verbunden und die Anode der zweiten Komparator-Diode ist mit einem Steuereingang der elektronischen Schalteinheit verbunden.

Bei der oben genannten Ausführung der Schutzschaltung mit einer nicht zur Erfindung gehörenden dynamischen Referenzladung ist der zweite Pol des Referenzladungswiderstands mit dem Einschaltpotential verbunden, die zweite Elektrode des Referenzladungskondensators ist mit dem Ausschaltpotential verbunden und die Anode der Komparator-Diode ist mit einem Steuereingang der elektronischen Schalteinheit verbunden.

Bei einem erfindungsgemäßen Verfahren zum Schutz eines Halbleiterschalters mit einem durch einen Gate-Treiber ansteuerbaren Gate wird eine Gate-Ladung des Gate erfasst und der Halbleiterschalter wird in Abhängigkeit von dem Wert der Gate-Ladung relativ zu einer Referenzladung abgeschaltet.

Der ersten oben genannten Ausführung einer erfindungsgemäßen Schutzschaltung entsprechend ist die Referenzladung bei einer ersten Verfahrensvariante zeitunabhängig und der Halbleiterschalter wird abgeschaltet, wenn nach dem Verstreichen einer Mindestzeitdauer nach einem Einschalten des Halbleiterschalters die Gate-Ladung die Referenzladung unterschreitet.

Bei einer nicht zur Erfindung gehörenden Schutzschaltung wird die Referenzladung bei einer zweiten Verfahrensvariante nach einem Einschalten des Halbleiterschalters während einer Anstiegsdauer von Null auf einen Endwert erhöht und der Halbleiterschalter wird abgeschaltet, wenn die Gate-Ladung die Referenzladung unterschreitet.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
- FIG 1: ein Blockschaltbild eines ersten Ausführungsbeispiels einer erfindungsgemäßen Schaltungsanordnung,
- FIG 2: einen Schaltplan einer erfindungsgemäßen Schaltungsanordnung gemäß dem ersten Ausführungsbeispiel,
- FIG 3: zeitliche Verläufe von Strömen und Spannungen der in FIG 2 gezeigten Schaltungsanordnung,
- FIG 4: ein Blockschaltbild eines zweiten Ausführungsbeispiels einer nicht erfindungsgemäßen Schaltungsanordnung,
- FIG 5: einen Schaltplan der nicht erfindungsgemäßen Schaltungsanordnung gemäß dem zweiten Ausführungsbeispiel,
- FIG 6: erste zeitliche Verläufe von Strömen und Spannungen der in FIG 5 gezeigten Schaltungsanordnung,
- FIG 7: zweite zeitliche Verläufe von Strömen und Spannungen der in FIG 5 gezeigten Schaltungsanordnung,
- FIG 8: ein Blockschaltbild eines dritten Ausführungsbeispiels einer nicht erfindungsgemäßen Schaltungsanordnung,
- FIG 9: einen Schaltplan der nicht erfindungsgemäßen Schaltungsanordnung gemäß dem dritten Ausführungsbeispiel.

Einander entsprechende Teile sind in den Figuren mit denselben Bezugszeichen versehen.

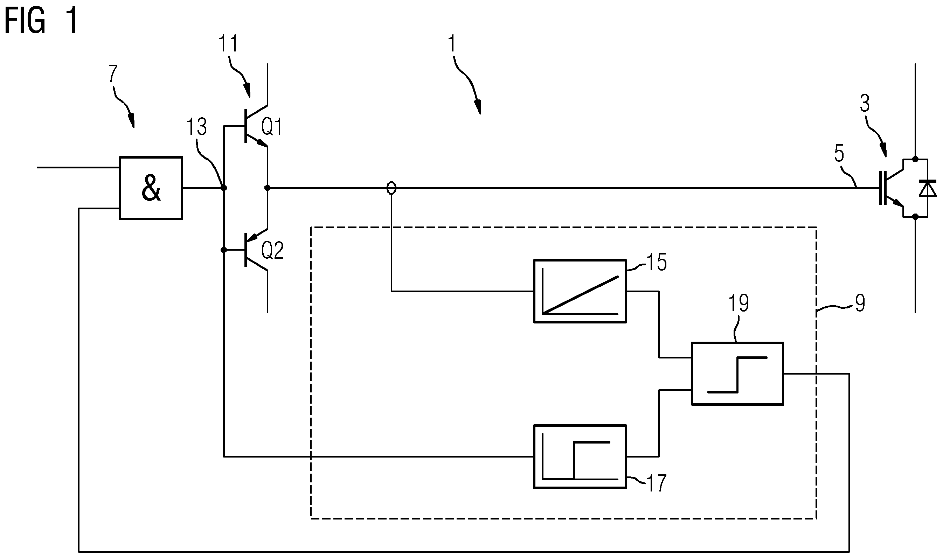

FIG 1 zeigt ein Blockschaltbild eines ersten Ausführungsbeispiels einer erfindungsgemäßen Schaltungsanordnung 1.

Die Schaltungsanordnung 1 umfasst einen Halbleiterschalter 3 mit einem Gate 5, einen Gate-Treiber 7 zum Ansteuern des Gate 5 und ein erstes Ausführungsbeispiel einer erfindungsgemäßen Schutzschaltung 9. Der Halbleiterschalter 3 dieses Ausführungsbeispiels ist ein IGBT.

Der Gate-Treiber 7 weist eine elektronische Schalteinheit 11 mit einer Gegentaktendstufe mit Endstufen-Bipolartransistoren Q1, Q2 und einem Steuereingang 13 auf.

Die Schutzschaltung 9 umfasst einen Integrator 15, ein Zeitglied 17 und eine Komparatoreinheit 19. Gemäß einer ersten Verfahrensvariante des erfindungsgemäßen Verfahrens wird mit dem Integrator 15 eine Gate-Ladung des Gate 5 erfasst, mit dem Zeitglied 17 wird eine Mindestzeitdauer zum Abschalten des Halbleiterschalters 3 nach einem Einschalten des Halbleiterschalters 3 eingestellt und mit der Komparatoreinheit 19 wird der Halbleiterschalter 3 abgeschaltet, wenn nach dem Verstreichen der Mindestzeitdauer nach einem Einschalten des Halbleiterschalters die Gate-Ladung die Referenzladung unterschreitet. Dabei ist die Referenzladung zeitunabhängig. Die Mindestzeitdauer wird derart gewählt, dass während der Mindestzeitdauer eine Gatekapazität und eine Millerkapazität des Halbleiterschalters nach einem Einschalten in einem Normalbetrieb des Halbleiterschalters zumindest annähernd vollständig, beispielsweise mindestens zu 90%, umgeladen sind. Der Halbleiterschalter 3 wird durch die Komparatoreinheit 19 dauerhaft oder nur für einen Taktzyklus des Gate-Treibers 7 abgeschaltet.

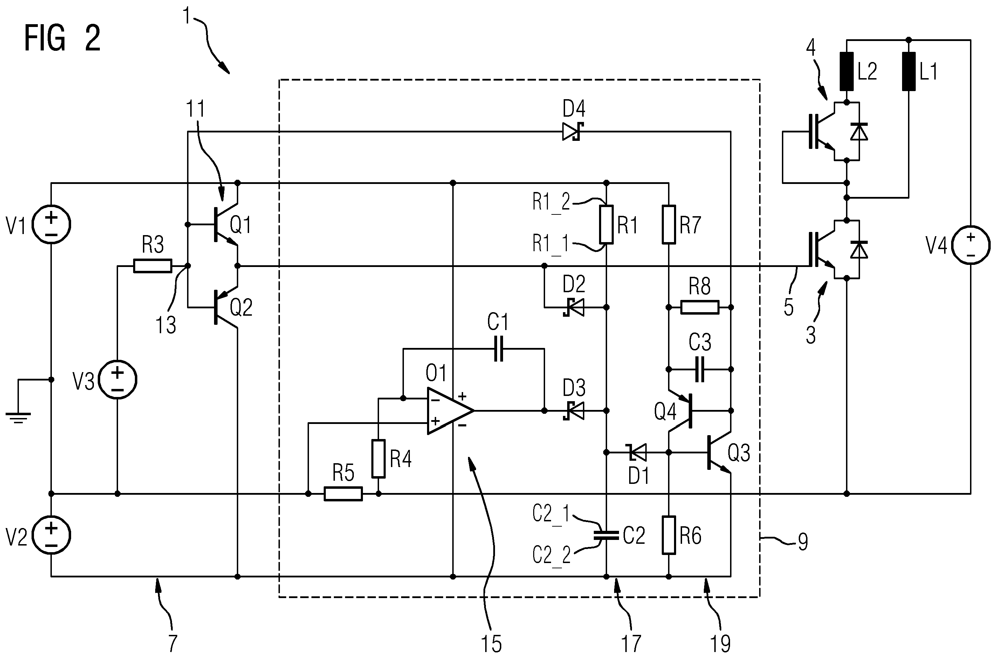

FIG 2 zeigt einen Schaltplan einer Schaltungsanordnung 1 gemäß dem ersten Ausführungsbeispiel.

Mit der elektronischen Schalteinheit 11 des Gate-Treibers 7 wird das Gate 5 zum Einschalten des Halbleiterschalters 3 mit einem Einschaltpotential und zum Ausschalten des Halbleiterschalters mit einem Ausschaltpotential verbunden. Das Einschaltpotential wird von einer Einschaltspannungsquelle V1 erzeugt. Das Ausschaltpotential wird von einer Ausschaltspannungsquelle V2 erzeugt. Die elektronische Schalteinheit 11 wird durch eine Treiberspannung gesteuert. Die Treiberspannung wird von einer Treiberspannungsquelle V3 über einen Treiberwiderstand R3 an den Steuereingang 13 der elektronischen Schalteinheit 11 gelegt. Die Spannungsquellen V1, V2, V3 sind jeweils Gleichspannungsquellen.

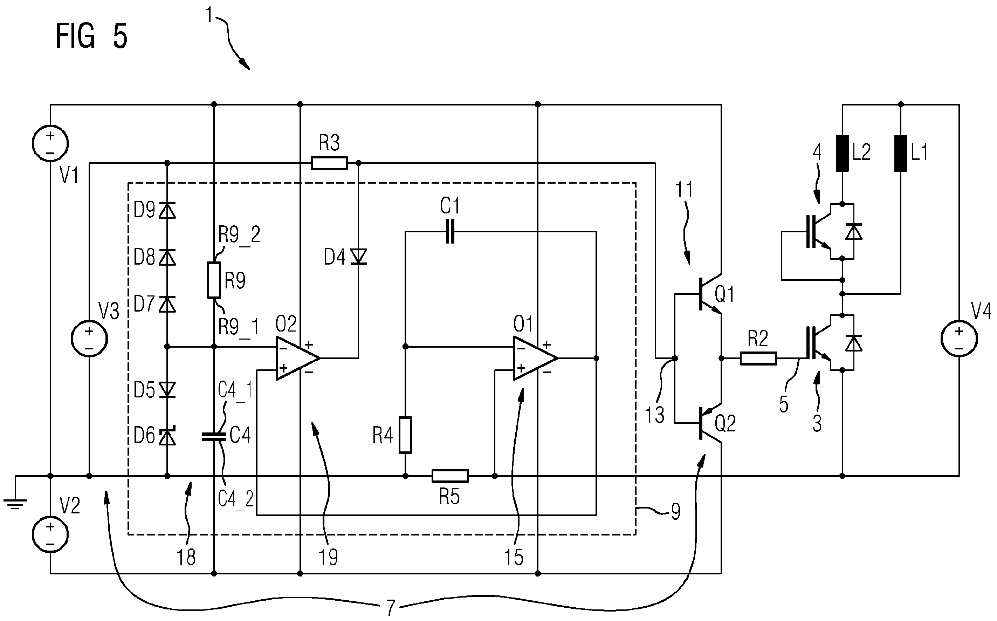

Der Integrator 15 der Schutzschaltung 9 weist einen Integrator-Operationsverstärker O1, einen Integrator-Kondensator C1 und einen Integrator-Widerstand R4 auf. Der Integrator-Kondensator C1 und der Integrator-Widerstand R4 stellen die Zeitkonstante des Integrators 15 ein. Der Integrator 15 erfasst die Gate-Ladung über eine an einem Messwiderstand R5 abfallende Spannung. Der Messwiderstand R5 ist mit dem Emitter des Halbleiterschalters 3 verbunden und wird in diesem Ausführungsbeispiel auch als Gate-Widerstand verwendet. Alternativ kann der Messwiderstand R5 in der Gate-Leitung des Halbleiterschalters 3 angeordnet werden, was aber höhere Anforderungen an den Integrator 15 stellt, da der Messwiderstand R5 dann abwechselnd an dem Einschaltpotential und dem Ausschaltpotential liegt. Ferner kann zusätzlich zu dem wie in FIG 2 angeordneten Messwiderstand R5 ein separater Gate-Widerstand R2 (siehe FIG 5) in die Gate-Leitung des Halbleiterschalters 3 geschaltet werden.

Das Zeitglied 17 weist einen Zeitglied-Widerstand R1, einen Zeitglied-Kondensator C2 und eine Zeitglied-Diode D2 auf. Die Anode der Zeitglied-Diode D2 ist mit einem ersten Pol R1_1 des Zeitglied-Widerstands R1 und einer ersten Elektrode C2_1 des Zeitglied-Kondensators C2 verbunden. Der Ausgang des Integrators 15 ist mit der Kathode einer Ausgangsdiode D3 verbunden, deren Anode mit der Anode der Zeitglied-Diode D2, dem ersten Pol R1_1 des Zeitglied-Widerstands R1 und der ersten Elektrode C2_1 des Zeitglied-Kondensators C2 verbunden ist.

Die Komparatoreinheit 19 weist einen npn-Bipolartransistor Q3, einen pnp-Bipolartransistor Q4, eine erste Komparator-Diode D1, eine zweite Komparator-Diode D4, einen Komparator-Kondensator C3, einen ersten Komparator-Widerstand R8, einen zweiten Komparator-Widerstand R6 und einen optionalen dritten Komparator-Widerstand R7 auf.

Der Kollektor des npn-Bipolartransistors Q3 ist mit der Basis des pnp-Bipolartransistors Q4 verbunden. Der Kollektor des pnp-Bipolartransistors Q4 ist mit der Basis des npn-Bipolartransistors Q3 und der Anode der ersten Komparator-Diode D1 verbunden. Der Komparator-Kondensator C3 und der erste Komparator-Widerstand R8 sind jeweils parallel zu der Basis-Emitter-Strecke des pnp-Bipolartransistors Q4 geschaltet. Der zweite Komparator-Widerstand R6 ist parallel zu der Basis-Emitter-Strecke des npn-Bipolartransistors Q3 geschaltet. Die Kathode der ersten Komparator-Diode D1 ist mit der Anode der Ausgangsdiode D3 verbunden. Der Emitter des npn-Bipolartransistors Q3 ist mit der zweiten Elektrode C2_2 des Zeitglied-Kondensators C2 verbunden. Der Emitter des pnp-Bipolartransistors Q4 ist über den dritten Komparator-Widerstand R7 mit dem zweiten Pol R1_2 des Zeitglied-Widerstands R1 verbunden. Die Basis des pnp-Bipolartransistors Q4 ist mit der Kathode der zweiten Komparator-Diode D4 verbunden.

Der Emitter des npn-Bipolartransistors Q3 ist mit dem Ausschaltpotential, das heißt mit dem negativen Pol der Ausschaltspannungsquelle V2 verbunden. Der zweite Pol R1_2 des Zeitglied-Widerstands R1 ist mit dem Einschaltpotential, das heißt mit dem positiven Pol der Einschaltspannungsquelle V1 verbunden. Die Anode der zweiten Komparator-Diode D4 ist mit dem Steuereingang 13 der elektronischen Schalteinheit 11 verbunden.

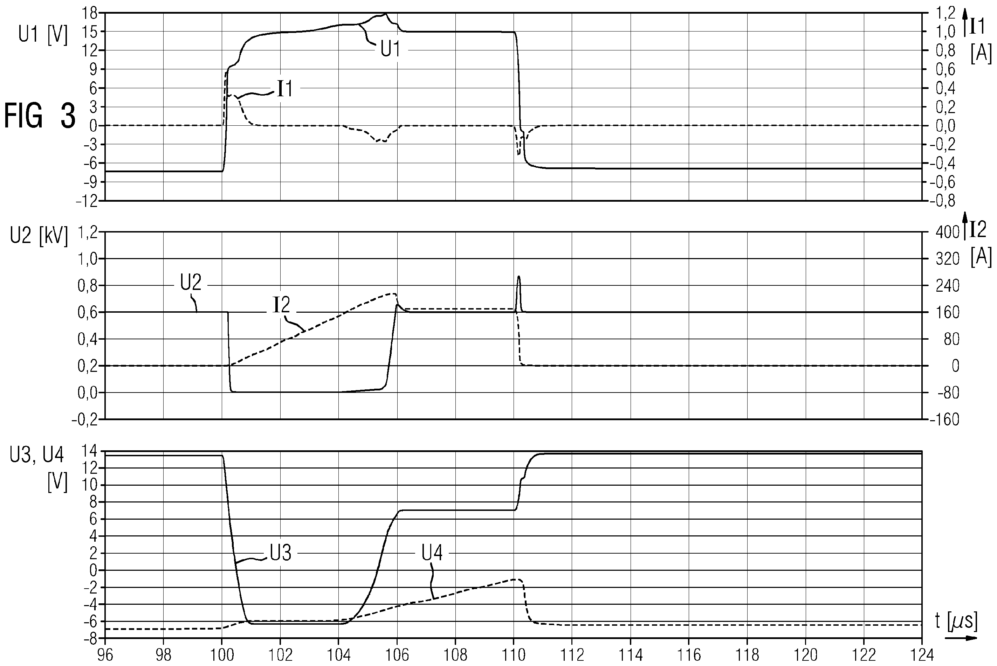

FIG 3 zeigt Verläufe von Strömen I1, I2 und Spannungen U1 bis U4 der in FIG 2 gezeigten Schaltungsanordnung 1 in Abhängigkeit von einer Zeit t im Fall, dass der Halbleiterschalter 3 nach dem Einschalten an seine Entsättigungsgrenze kommt. Die Verläufe wurden mit einer Simulation erzeugt, bei der der Halbleiterschalter 3 wie in FIG 2 gezeigt mit einem zweiten Halbleiterschalter 4 zu einer Halbbrücke verschaltet ist und eine mit der Halbbrücke verbundene Last durch eine Lastinduktivität L1, eine Streuinduktivität L2 und eine Lastspannungsquelle V4 simuliert wurde. Die Lastspannungsquelle V4 ist eine Gleichspannungsquelle. Die Streuinduktivität L2 ist in Reihe mit dem zweiten Halbleiterschalter 4 geschaltet. Die Lastinduktivität L1 ist parallel zu der Reihenschaltung der Streuinduktivität L2 und des zweiten Halbleiterschalters 4 geschaltet.

Die Simulation wurde für einen Messwiderstand R5 von 10 Ω, einen Treiberwiderstand R3 von 1,5 kΩ, einen Integrator-Kondensator C1 mit der Kapazität von 500 pF, einen Integrator-Widerstand R4 von 220 Ω,einen Zeitglied-Widerstand R1 von 2,2 kΩ, einen Zeitglied-Kondensator C2 mit der Kapazität von 10 nF, einen Komparator-Kondensator C3 mit der Kapazität von 2 nF, einen ersten Komparator-Widerstand R8 von 470 Ω, einen zweiten Komparator-Widerstand R6 von 470 Ω,einen dritten Komparator-Widerstand R7 von 2,2 kΩ, eine Lastinduktivität L1 von 15 µH, eine Streuinduktivität L2 von 150 nH, eine Einschaltspannungsquelle V1 von 15 V, eine Ausschaltspannungsquelle V2 von 8 V, eine Lastspannungsquelle V4 von 600 V, als Schottky-Dioden ausgebildete Dioden D2, D3, D4 und eine als Z-Diode ausgebildete Diode D1 durchgeführt.

Etwa 100 µs nach dem Beginn der Simulation wird der Halbleiterschalter 3 eingeschaltet. Daraufhin steigen eine Gate-Emitter-Spannung U1, ein Gate-Strom I1 und ein Kollektor-Strom I2 des Halbleiterschalters 3 an und eine Kollektor-Spannung U2 des Halbleiterschalters 3 fällt schnell auf etwa 0 V ab. Gleichzeitig sinkt eine Integrator-Ausgangsspannung U3 am Ausgang des negierenden Integrator-Operationsverstärkers O1 und ein Steuersignal U4, das eine Spannung zwischen den Elektroden C2_1, C2_2 des Zeitglied-Kondensators C2 ist, steigt. Kurz nach dem Einschalten des Halbleiterschalters 3 sinkt der Gate-Strom I1 wieder auf 0 **A.** Nachdem der Gate-Strom I1 wieder auf 0 A gesunken ist, bleiben die Integrator-Ausgangsspannung U3 und das Steuersignal U4 zunächst konstant. Die Gate-Emitter-Spannung U1 und der Kollektor-Strom I2 steigen jedoch weiter an.

Etwa 104,5 µs nach dem Beginn der Simulation kommt der Halbleiterschalter 3 an seine Entsättigungsgrenze und die Kollektor-Spannung U2 steigt wieder an (zunächst nur langsam). Daraufhin beginnt sich die Millerkapazität des Halbleiterschalters 3 aufzuladen und der Gate-Strom I1 beginnt in umgekehrter Richtung zu fließen (er fließt ins Gate 5 zurück). Der zurückfließende Gate-Strom I1 lässt die Integrator-Ausgangsspannung U3 ansteigen.

Etwa 106 µs nach dem Beginn der Simulation ist die Millerkapazität des Halbleiterschalters 3 voll aufgeladen, der Gate-Strom I1 wird wieder 0 A und die Integrator-Ausgangsspannung U3 und die Kollektor-Spannung U2 nehmen jeweils konstante Werte an. Das Steuersignal U4 steigt jedoch weiter. Etwa 110 µs nach dem Beginn der Simulation erreicht die erste Elektrode C2_1 des Zeitglied-Kondensators C2 eine Spannung, bei der die erste Komparator-Diode D1 und die Basis-Emitter-Strecke des npn-Bipolartransistors Q3 leitend werden. Schließlich zündet die von dem npn-Bipolartransistor Q3 und dem pnp-Bipolartransistor Q4 gebildete Thyristorstruktur über die erste Komparator-Diode D1 und der Halbleiterschalter 3 wird abgeschaltet. Die Zenerspannung der ersten Komparator-Diode D1 definiert hier die Referenzladung. Der dritte Komparator-Widerstand R7 der in FIG 2 gezeigten Schaltungsanordnung 1 bewirkt, dass der Halbleiterschalter 3 dauerhaft abgeschaltet wird. Wenn der dritte Komparator-Widerstand R7 entfernt wird, wird der Halbleiterschalter 3 nur für einen Taktzyklus des Gate-Treibers 7 abgeschaltet.

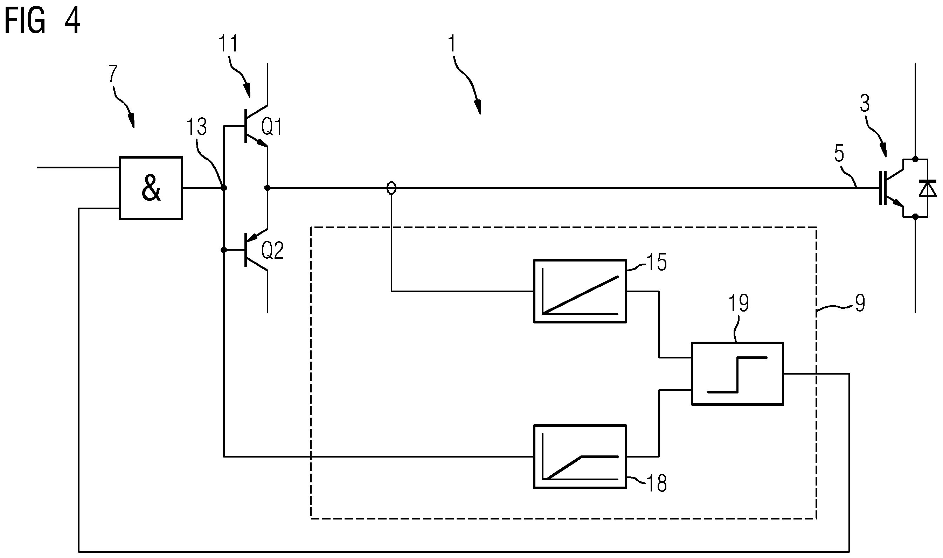

FIG 4 zeigt ein Blockschaltbild eines zweiten Ausführungsbeispiels einer nicht erfindungsgemäßen Schaltungsanordnung 1.

Die Schaltungsanordnung 1 dieses Ausführungsbeispiels unterscheidet sich von der in FIG 1 gezeigten Schaltungsanordnung 1 dadurch, dass sie kein Zeitglied 17, sondern stattdessen eine Referenzladungsschaltung 18 aufweist. Gemäß einer zweiten Verfahrensvariante eines nicht erfindungsgemäßen Verfahrens wird mit dem Integrator 15 eine Gate-Ladung des Gate 5 erfasst, mit der Referenzladungsschaltung 18 wird eine Referenzladung nach einem Einschalten des Halbleiterschalters 3 während einer Anstiegszeit von Null auf einen Endwert erhöht und mit der Komparatoreinheit 19 wird der Halbleiterschalter 3 abgeschaltet, wenn die Gate-Ladung die Referenzladung unterschreitet. Die Anstiegsdauer wird derart gewählt, dass während der Mindestzeitdauer eine Gatekapazität und eine Millerkapazität des Halbleiterschalters nach dem Verstreichen der Anstiegsdauer nach einem Einschalten in einem Normalbetrieb des Halbleiterschalters 3 zumindest annähernd vollständig, beispielsweise mindestens zu 90%, umgeladen sind. Der Halbleiterschalter 3 wird durch die Komparatoreinheit 19 für einen Taktzyklus des Gate-Treibers 7 abgeschaltet.

FIG 5 zeigt einen Schaltplan einer Schaltungsanordnung 1 gemäß dem zweiten Ausführungsbeispiel.

Der Gate-Treiber 7 und der Integrator 15 sind wie bei der in FIG 2 gezeigten Schaltungsanordnung 1 ausgebildet. Der Integrator 15 erfasst die Gate-Ladung über eine an einem Messwiderstand R5 abfallende Spannung. Der Messwiderstand R5 ist mit dem Emitter des Halbleiterschalters 3 verbunden. Der Gate-Treiber 7 ist mit dem Gate 5 des Halbleiterschalters 3 über einen Gate-Widerstand R2 verbunden. In einer alternativen Ausführung der Schaltungsanordnung 1 kann auf den Messwiderstand R5 verzichtet und die Spannung für den Integrator 15 an dem Gate-Widerstand R2 abgegriffen werden, siehe dazu auch die Bemerkungen in der Beschreibung der FIG **2****.**

Die Komparatoreinheit 19 weist einen Komparator-Operationsverstärker O2 und eine Komparator-Diode D4 auf. Die Referenzladungsschaltung 18 weist einen Referenzladungskondensator C4, einen Referenzladungswiderstand R9, eine erste Referenzladungsdiode D5 und eine zweite Referenzladungsdiode D6, die eine Z-Diode ist, auf. Der positive Eingang des Komparator-Operationsverstärkers O2 ist mit dem Ausgang des Integrators 15 verbunden. Der negative Eingang des Komparator-Operationsverstärkers O2 ist mit einem ersten Pol R9_1 des Referenzladungswiderstands R9, einer ersten Elektrode C4_1 des Referenzladungskondensators C4 und der Anode der ersten Referenzladungsdiode D5 verbunden. Der Ausgang des Komparator-Operationsverstärkers O2 ist mit der Kathode der Komparator-Diode D4 verbunden. Die Kathode der ersten Referenzladungsdiode D5 ist mit der Kathode der zweiten Referenzladungsdiode D6 verbunden. Die Anode der zweiten Referenzladungsdiode D6 ist mit dem Eingang des Integrators 15 verbunden. Ferner ist die Anode der ersten Referenzladungsdiode D5 über eine Reihenschaltung von Rücksetzdioden D7, D8, D9 mit dem positiven Pol der Treiberspannungsquelle V3 verbunden.

Der zweite Pol R9_2 des Referenzladungswiderstands R9 ist mit dem Einschaltpotential, das heißt mit dem positiven Pol der Einschaltspannungsquelle V1 verbunden. Die zweite Elektrode C4_2 des Referenzladungskondensators C4 ist mit Ausschaltpotential, das heißt mit dem negativen Pol der Ausschaltspannungsquelle V2 verbunden. Die Anode der Komparator-Diode D4 ist mit einem Steuereingang 13 der elektronischen Schalteinheit 11 verbunden.

Bei der in FIG 5 gezeigten Schaltungsanordnung 1 arbeitet der Integrator 15 im Unterschied zu dem in FIG 2 gezeigten Ausführungsbeispiel nicht negierend. Der Referenzladungswiderstand R9 und der Referenzladungskondensator C4 legen die Anstiegsdauer fest, innerhalb derer die Referenzladung nach dem Einschalten des Halbleiterschalters 3 auf ihren Endwert steigt. Der Endwert wird erreicht, wenn die Spannung an dem Referenzladungskondensator C4 die Summe der Vorwärtsspannung der ersten Referenzladungsdiode D5 und der Zener-Spannung der zweiten Referenzladungsdiode D6 erreicht. Nach dem Erreichen des Endwerts bleibt die Spannung an dem Referenzladungskondensator C4 konstant. Nach dem Einschalten des Halbleiterschalters 3 steigt die Gate-Ladung des Gate 5, die mit dem Integrator 15 gemessen wird und mit der Referenzladung mittels des Komparator-Operationsverstärkers O2 verglichen wird. Im fehlerfreien Betrieb des Halbleiterschalters 3 ist die Gate-Ladung stets höher als die Referenzladung. Im Fehlerfall sinkt die Gate-Ladung unter die Referenzladung und der Halbleiterschalter 3 wird durch die Komparatoreinheit 19 abgeschaltet. Die Rücksetzdioden D7, D8, D9 dienen zum schnellen Rücksetzen der Referenzladung nach einem Ausschalten des Halbleiterschalters 3.

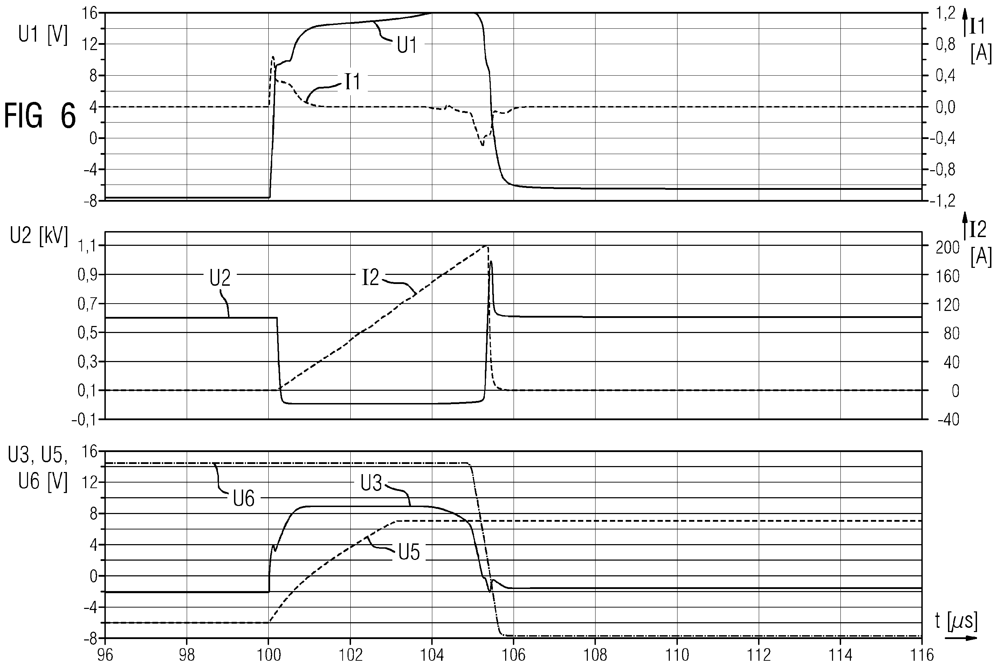

FIG 6 zeigt zeitliche Verläufe von Strömen I1, I2 und Spannungen U1 bis U3, U5, U6 der in FIG 5 gezeigten Schaltungsanordnung 1 im Fall, dass der Halbleiterschalter 3 nach dem Einschalten an seine Entsättigungsgrenze kommt. Die Verläufe wurden mit einer Simulation erzeugt, bei der Halbleiterschalter 3 wie bereits in FIG 2 mit einem zweiten Halbleiterschalter 4 zu einer Halbbrücke verschaltet ist und eine mit der Halbbrücke verbundene Last durch Induktivitäten L1, L2 und eine Lastspannungsquelle V4 simuliert wurde.

Die Simulation wurde für einen Messwiderstand R5 von 6,8 Ω, einen Treiberwiderstand R3 von 1 kΩ, einen Gate-Widerstand R2 von 6,8 Ω,einen Integrator-Kondensator C1 mit der Kapazität von 100 pF, einen Integrator-Widerstand R4 von 1,5 kΩ, einen Referenzladungskondensator C4 mit der Kapazität von 620 pF, einen Referenzladungswiderstand R9 von 4,7 kΩ, eine Lastinduktivität L1 von 15 µH, eine Streuinduktivität L2 von 150 nH, eine Einschaltspannungsquelle V1 von 15 V, eine Ausschaltspannungsquelle V2 von 8 V und eine Lastspannungsquelle V4 von 600 V durchgeführt.

Etwa 100 µs nach dem Beginn der Simulation wird der Halbleiterschalter 3 eingeschaltet. Daraufhin steigt die Gate-Emitter-Spannung U1, der Gate-Strom I1 steigt kurzzeitig an, ein Kollektor-Strom I2 des Halbleiterschalters 3 steigt an und die Kollektor-Spannung U2 des Halbleiterschalters 3 fällt schnell auf etwa 0 V ab. Gleichzeitig steigen die Integrator-Ausgangsspannung U3 am Ausgang des nicht negierenden Integrator-Operationsverstärkers O1 und eine am negativen Eingang des Komparator-Operationsverstärkers O2 anliegende Referenzspannung U5, die ein Maß für die Referenzladung ist, wobei die Integrator-Ausgangsspannung U3 größer als die Referenzspannung U5 ist, weil die Gate-Ladung größer als die Referenzladung ist.

Etwa 104,5 µs nach dem Beginn der Simulation kommt der Halbleiterschalter 3 an seine Entsättigungsgrenze und die Kollektor-Spannung U2 steigt wieder an (zunächst nur langsam). Daraufhin beginnt sich die Millerkapazität des Halbleiterschalters 3 aufzuladen und der Gate-Strom I1 beginnt in umgekehrter Richtung zu fließen (er fließt ins Gate 5 zurück). Der zurückfließende Gate-Strom I1 lässt die Integrator-Ausgangsspannung U3 absinken.

Etwa 105 µs nach dem Beginn der Simulation fällt die Integrator-Ausgangsspannung U3 unter die Referenzspannung U5, weil die Gate-Ladung unter die Referenzladung fällt. Dies wird von dem Komparator-Operationsverstärkers O2 detektiert und eine Komparator-Ausgangsspannung U6 am Ausgang des Komparator-Operationsverstärkers O2 sinkt auf die Ausschaltspannung von -8 V, wodurch der Halbleiterschalter 3 abgeschaltet wird. Im Unterschied zu der in FIG 3 gezeigten Simulation kommt es in diesem Fall nicht zu einer Entsättigung des Halbleiterschalters 3, da keine Mindestzeitdauer vor dem Abschalten des Halbleiterschalters 3 abgewartet wird, so dass der Halbleiterschalter 3 schneller abgeschaltet wird.

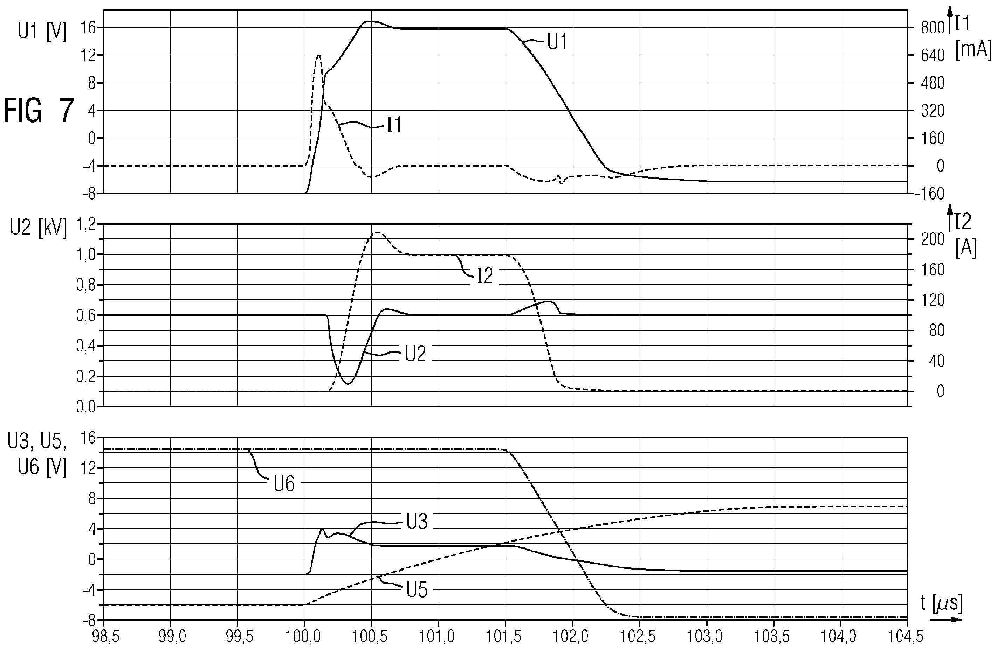

FIG 7 zeigt zeitliche Verläufe der Ströme I1, I2 und Spannungen U1 bis U3, U5, U6 der in FIG 5 gezeigten Schaltungsanordnung 1, wobei diese Verläufe mit einer Simulation für eine Lastinduktivität L1 von 0,5 µH durchgeführt wurden, während alle weiteren Parameter der Simulation wie bei der in FIG 6 gezeigten Simulation gewählt wurden. Im Unterschied zu der in FIG 6 gezeigten Simulation erreicht die Kollektorspannung U2 in diesem Fall nicht das Sättigungsniveau und die Millerkapazität des Halbleiterschalters 3 wird kaum geladen. Die Gate-Ladung und die Integrator-Ausgangsspannung U3 steigen daher nach dem Einschalten des Halbleiterschalters 3 auf weniger hohe Werte als bei der in FIG 6 gezeigten Simulation, so dass die Integrator-Ausgangsspannung U3 früher unter die Referenzspannung U5 fällt und der Komparator 19 daraufhin den Halbleiterschalter 3 abschaltet. Der Kollektor-Strom I2 dauert weniger als 2 µs an (etwa 1,7 µs). Dies zeigt, dass das in FIG 5 gezeigte zweite Ausführungsbeispiel einer erfindungsgemäßen Schutzschaltung 9 bei kleiner Lastinduktivität L1 ein sehr schnelles Abschalten eines Halbleiterschalters 3 bewirken kann.

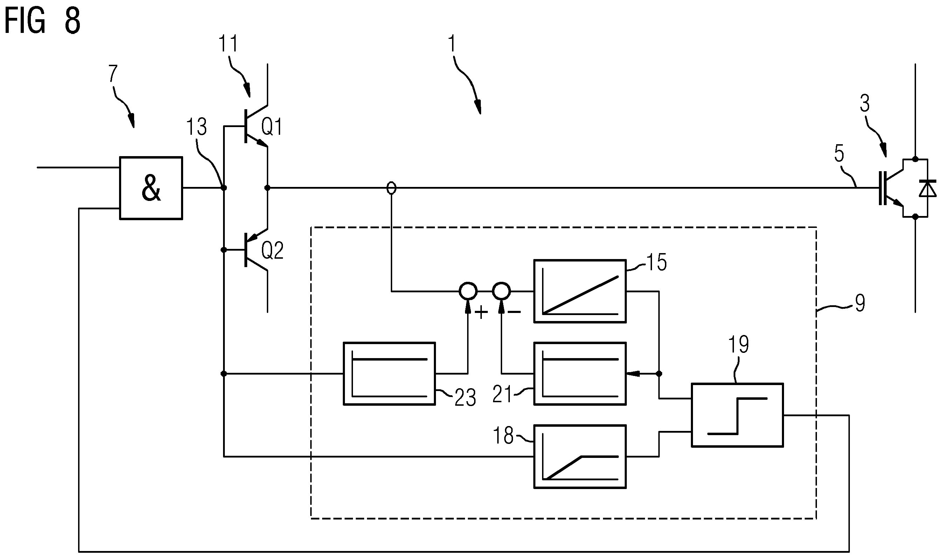

FIG 8 zeigt ein Blockschaltbild eines dritten Ausführungsbeispiels einer nicht erfindungsgemäßen Schaltungsanordnung **1.** Dieses Ausführungsbeispiel unterscheidet sich von dem in FIG 4 gezeigten Ausführungsbeispiel lediglich dadurch, dass die Schutzschaltung 9 zwei P-Glieder 21, 23 zur Kompensation einer Eingangs-Offset-Spannung des Integrators 15 aufweist. Ein erstes P-Glied 21 ist zwischen den Ausgang und den negativen Eingang des Integrators 15 geschaltet. Das zweite P-Glied 23 ist zwischen den positiven Eingang des Integrators 15 und den Steuereingang 13 der elektronischen Schalteinheit 11 des Gate-Treibers 7 geschaltet.

Die P-Glieder 21, 23 verhindern, dass eine Eingangs-Offset-Spannung an einem Eingang des Integrator-Operationsverstärkers O1 zu einem unerwünschten Driften der Ausgangsspannung des Integrator-Operationsverstärkers O1 führt. Die P-Glieder 21, 23 werden derart bemessen, dass die Eingangs-Offset-Spannung kompensiert wird und der Drift der Ausgangsspannung genügend Abstand zu einer Versorgungsspannung des Integrator-Operationsverstärkers O1 hält, um dessen sichere Funktion zu gewährleisten.

Das erste P-Glied 21 sorgt mit einer invertierten Rückführung des Integratorausgangssignals auf den Eingang des Integrators 15 dafür, dass der Integrator 15 nicht in die Begrenzung gehen kann. Die Verstärkung des Integratorausgangssignals durch das erste P-Glied 21 wird durch einen hochohmigen Widerstand so gering gehalten, dass ein Fehler langsam ausgeglichen wird. Diese Rückführung allein würde den Integrator 15 langsam wieder zu Null laufen lassen. Um dies zu verhindern, wird das Treibersignal am Steuereingang 13 der elektronischen Schalteinheit 11 des Gate-Treibers 7 mit einer ebenso geringen Verstärkung des zweiten P-Glieds 23 nichtinvertierend auf den Eingang des Integrators 15 gegeben. Somit wird der Integrator 15 gezwungen, für das Ein- und Ausschalten auf vordefinierten Werten jeweils mit einer langen Integrationskonstante zu verharren. Eine Eingangs-Offset-Spannung des Integrator-Operationsverstärkers O1 verschiebt diese Werte in einer gewissen Höhe, soweit es das erste P-Glied 21 zulässt. Die Integrationskonstante des Integrators 15 wird so gewählt, dass jede vollständige Umladung des Gate 5 den Ausgang des Integrators 15 genau auf diese beiden vordefinierten Werte wechselweise "springen" lässt. Schnelle Vorgänge wie das Entsättigen des Halbleiterschalters 3 werden von den P-Gliedern 21, 23 nicht kompensiert und getreu verarbeitet.

Zusammenfassend wird mit den P-Gliedern 21, 23 eine Eingangs-Offset-Spannung des Integrator-Operationsverstärkers O1 mit einer tolerierbaren Restabweichung kompensiert, während schnelle Vorgänge wie das Umladen des Gate 5 beziehungsweise das Entsättigen des Halbleiterschalters 3 nicht von der Kompensation betroffen sind.

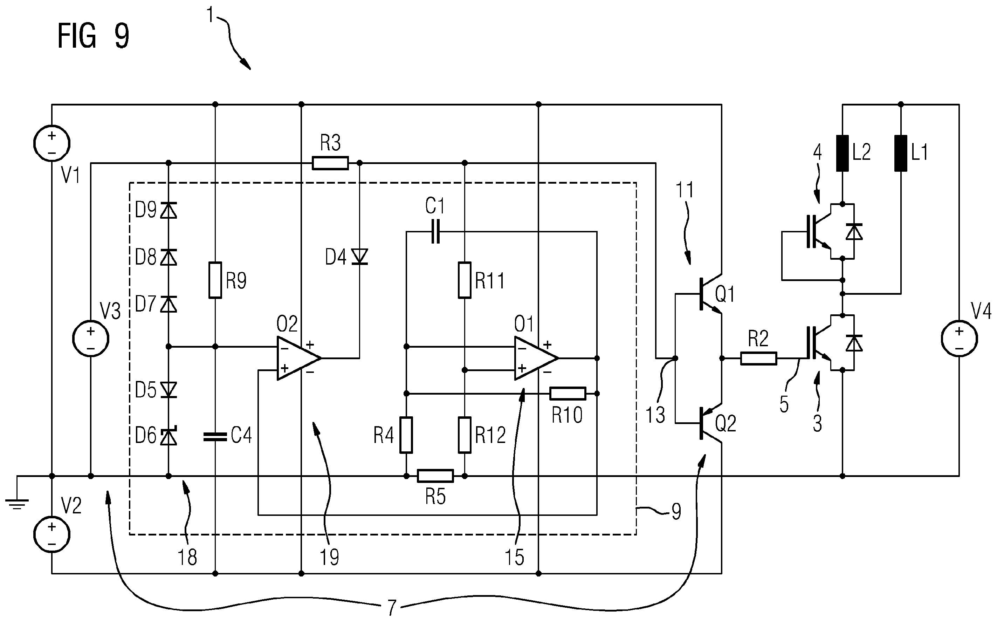

FIG 9 zeigt einen Schaltplan einer Schaltungsanordnung 1 gemäß dem dritten Ausführungsbeispiel. Die Schaltungsanordnung 1 unterscheidet sich von der in FIG 5 gezeigten Schaltungsanordnung 1 lediglich durch drei P-Glied-Widerstände R10, R11, R12. Ein erster P-Glied-Widerstand R10 ist zwischen den Ausgang und den negativen Eingang des Integrator-Operationsverstärkers O1 geschaltet. Ein zweiter P-Glied-Widerstand R11 ist zwischen den positiven Eingang des Integrator-Operationsverstärkers O1 und den Steuereingang 13 der elektronischen Schalteinheit 11 des Gate-Treibers 7 geschaltet. Der dritte P-Glied-Widerstand R12 ist zwischen den Emitter des Halbleiterschalters 3 und den positiven Eingang des Integrator-Operationsverstärkers O1 geschaltet. Der erste P-Glied-Widerstand R10 hat beispielsweise einen Widerstandswert von etwa 2000 kΩ, der zweite P-Glied-Widerstand R11 hat beispielsweise einen Widerstandswert von etwa 300 kΩ, der dritte P-Glied-Widerstand R12 hat beispielsweise einen Widerstandswert von etwa 100 Ω. Der erste P-Glied-Widerstand R10 und der Integrator-Widerstand R4 bilden das erste P-Glied 21, der zweite P-Glied-Widerstand R11 und der dritte P-Glied-Widerstand R12 bilden das zweite P-Glied 23 (siehe FIG 8).

Alle in den Figuren 1 bis 9 gezeigten Ausführungsbeispiele einer erfindungsgemäßen Schaltungsanordnung 1 können analog auch mit einem MOSFET statt mit einem IGBT als Halbleiterschalter 3 und/oder mit einem anders ausgeführten Gate-Treiber 7, beispielsweise mit einem Gate-Treiber 7, dessen elektronische Schalteinheit 11 eine Endstufe mit komplementären Endstufen-MOSFET statt eine Gegentaktendstufe mit Endstufen-Bipolartransistoren Q1, Q2 aufweist, ausgeführt werden.

## Patentansprüche

1. Schutzschaltung (9) für einen Halbleiterschalter (3) mit einem durch einen Gate-Treiber (7) ansteuerbaren Gate (5),
die Schutzschaltung (9) umfassend
- einen Integrator (15) zum Erfassen einer Gate-Ladung des Gate (5) über eine Integrator-Ausgangsspannung (U3) des Integrators (15),
- eine Komparatoreinheit (19) zum Abschalten des Halbleiterschalters (3) in Abhängigkeit von dem Wert der Gate-Ladung relativ zu einer Referenzladung und
- ein Zeitglied (17) zum Einstellen einer Mindestzeitdauer zwischen einem Einschalten des Halbleiterschalters (3) und dem Abschalten des Halbleiterschalters (3) durch die Komparatoreinheit (19),
- wobei die Referenzladung zeitunabhängig ist und die Komparatoreinheit (19) dazu ausgebildet ist, den Halbleiterschalter (3) abzuschalten, wenn die Gate-Ladung die Referenzladung unterschreitet,
- wobei die Mindestzeitdauer derart gewählt ist, dass während der Mindestzeitdauer eine Gatekapazität und eine Millerkapazität des Halbleiterschalters (3) nach einem Einschalten in einem Normalbetrieb des Halbleiterschalters (3) zumindest annähernd vollständig, beispielsweise mindestens zu 90%, umgeladen sind,
- **dadurch gekennzeichnet, dass** das Zeitglied (17) einen Zeitglied-Widerstand (R1), einen Zeitglied-Kondensator (C2) und eine Zeitglied-Diode (D2) aufweist, die Anode der Zeitglied-Diode (D2) mit einem ersten Pol (R1_1) des Zeitglied-Widerstands (R1) und einer ersten Elektrode (C2_1) des Zeitglied-Kondensators (C2) verbunden ist und ein Ausgang des Integrators (15) mit der Kathode einer Ausgangsdiode (D3) verbunden ist, deren Anode mit der Anode der Zeitglied-Diode (D2), dem ersten Pol (R1_1) des Zeitglied-Widerstands (R1) und der ersten Elektrode (C2_1) des Zeitglied-Kondensators (C2) verbunden ist und
- wobei die Komparatoreinheit (19) einen npn-Bipolartransistor (Q3), einen pnp-Bipolartransistor (Q4), eine erste Komparator-Diode (D1), eine zweite Komparator-Diode (D4), einen Komparator-Kondensator (C3), einen ersten Komparator-Widerstand (R8), einen zweiten Komparator-Widerstand (R6) und einen dritten Komparator-Widerstand (R7) aufweist, der Kollektor des npn-Bipolartransistors (Q3) mit der Basis des pnp-Bipolartransistors (Q4) verbunden ist, der Kollektor des pnp-Bipolartransistors (Q4) mit der Basis des npn-Bipolartransistors (Q3) und der Anode der ersten Komparator-Diode (D1) verbunden ist, der Komparator-Kondensator (C3) und der erste Komparator-Widerstand (R8) jeweils parallel zu der Basis-Emitter-Strecke des pnp-Bipolartransistors (Q4) geschaltet sind, der zweite Komparator-Widerstand (R6) parallel zu der Basis-Emitter-Strecke des npn-Bipolartransistors (Q3) geschaltet ist, die Kathode der ersten Komparator-Diode (D1) mit der Anode der Ausgangsdiode (D3) verbunden ist, der Emitter des npn-Bipolartransistors (Q3) mit der zweiten Elektrode (C2_2) des Zeitglied-Kondensators (C2) verbunden ist, der Emitter des pnp-Bipolartransistors (Q4) über den dritten Komparator-Widerstand (R7) mit dem zweiten Pol (R1_2) des Zeitglied-Widerstands (R1) verbunden ist und die Basis des pnp-Bipolartransistors (Q4) mit der Kathode der zweiten Komparator-Diode (D4) verbunden ist.

2. Schaltungsanordnung (1), umfassend
- einen Halbleiterschalter (3) mit einem Gate (5),
- einen Gate-Treiber (7) zum Ansteuern des Gate (5), wobei der Gate-Treiber (7) eine durch eine Treiberspannung des Gate-Treibers (7) steuerbare elektronische Schalteinheit (11) aufweist, mit der das Gate (5) zum Einschalten des Halbleiterschalters (3) mit einem Einschaltpotential und zum Ausschalten des Halbleiterschalters (3) mit einem Ausschaltpotential verbunden wird, und
- eine Schutzschaltung (9) nach Anspruch 1.

3. Schaltungsanordnung (1) nach Anspruch 2, wobei der Emitter des npn-Bipolartransistors (Q3) mit dem Ausschaltpotential verbunden ist, der zweite Pol (R1_2) des Zeitglied-Widerstands (R1) mit dem Einschaltpotential verbunden ist und die Anode der zweiten Komparator-Diode (D4) mit einem Steuereingang (13) der elektronischen Schalteinheit (11) verbunden ist.

4. Schaltungsanordnung (1) nach einem der Ansprüche 2 oder und 3,
wobei der zweite Pol (R9_2) des Referenzladungswiderstands (R9) mit dem Einschaltpotential verbunden ist, die zweite Elektrode (C4_2) des Referenzladungskondensators (C4) mit dem Ausschaltpotential verbunden ist und die Anode der Komparator-Diode (D4) mit einem Steuereingang (13) der elektronischen Schalteinheit (11) verbunden ist.

5. Verfahren zum Schutz eines Halbleiterschalters (3) mit einem durch einen Gate-Treiber (7) ansteuerbaren Gate (5) mittels einer Schutzschaltung (9) nach Anspruch 1 oder mittels einer Schaltungsanordnung (1) nach einem der Ansprüche 2 bis 4, wobei
- eine Gate-Ladung des Gate (5) erfasst wird und
- der Halbleiterschalter (3) in Abhängigkeit von dem Wert der Gate-Ladung relativ zu einer Referenzladung abgeschaltet wird, wobei
- die Referenzladung zeitunabhängig ist und
- der Halbleiterschalter (3) abgeschaltet wird, wenn nach dem Verstreichen einer Mindestzeitdauer nach einem Einschalten des Halbleiterschalters (3) die Gate-Ladung die Referenzladung unterschreitet.

## Claims

1. Protection circuit (9) for a semiconductor switch (3) having a gate (5) which is controllable by a gate driver (7), the protection circuit (9) comprising
- an integrator (15) for detecting a gate charge of the gate (5) via an integrator output voltage (U3) of the integrator (15),
- a comparator unit (19) for switching off the semiconductor switch (3) dependent upon the value of the gate charge relative to a reference charge, and
- a timer element (17) for setting a minimum duration between a switching-on of the semiconductor switch (3) and the switching-off of the semiconductor switch (3) by the comparator unit (19),
- wherein the reference charge is time-independent and the comparator unit (19) is configured to switch off the semiconductor switch (3) if the gate charge falls below the reference charge,
- wherein the minimum duration is selected such that, during the minimum duration, a gate capacitance and a Miller capacitance of the semiconductor switch (3) after switching into a normal operation of the semiconductor switch (3) are recharged at least approximately completely, for example to at least 90%,
- **characterised in that** the timer element (17) has a timer element resistor (R1), a timer element capacitor (C2) and a timer element diode (D2), the anode of the timer element diode (D2) is connected to a first pole (R1_1) of the timer element resistor (R1) and a first electrode (C2_1) of the timer element capacitor (C2) and an output of the integrator (15) is connected to the cathode of an output diode (D3), the anode of which is connected to the anode of the timer element diode (D2), the first pole (R1_1) of the timer element resistor (R1) and the first electrode (C2_1) of the timer element capacitor (C2) and
- wherein the comparator unit (19) has an npn-bipolar transistor (Q3), a pnp-bipolar transistor (Q4), a first comparator diode (D1), a second comparator diode (D4), a comparator capacitor (C3), a first comparator resistor (R8), a second comparator resistor (R6) and a third comparator resistor (R7), the collector of the npn-bipolar transistor (Q3) is connected to the base of the pnp-bipolar transistor (Q4), the collector of the pnp-bipolar transistor (Q4) is connected to the base of the npn-bipolar transistor (Q3) and the anode of the first comparator diode (D1), the comparator capacitor (C3) and the first comparator resistor (R8) are each connected in parallel with the base-emitter path of the pnp-bipolar transistor (Q4), the second comparator resistor (R6) is connected in parallel with the base-emitter path of the npn-bipolar transistor (Q3), the cathode of the first comparator diode (D1) is connected to the anode of the output diode (D3), the emitter of the npn-bipolar transistor (Q3) is connected to the second electrode (C2_2) of the timer element capacitor (C2), the emitter of the pnp-bipolar transistor (Q4) is connected via the third comparator resistor (R7) to the second pole (R1_2) of the timer element resistor (R1), and the base of the pnp-bipolar transistor (Q4) is connected to the cathode of the second comparator diode (D4).

2. Circuit arrangement (1), comprising
- a semiconductor switch (3) with a gate (5),
- a gate driver (7) for controlling the gate (5), wherein the gate driver (7) has an electronic switching unit (11) which is controllable by a driver voltage of the gate driver (7), to which switch unit (11) the gate (5) is connected for switching-on the semiconductor switch (3) with a switch-on potential and for switching off the semiconductor switch (3) with a switch-off potential, and
- a protection circuit (9) according to claim 1.

3. Circuit arrangement (1) according to claim 2, wherein the emitter of the npn-bipolar transistor (Q3) is connected to the switch-off potential, the second pole (R1_2) of the timer element resistor (R1) is connected to the switch-on potential and the anode of the second comparator diode (D4) is connected to a control input (13) of the electronic switching unit (11).

4. Circuit arrangement (1) according to one of claims 2 or and 3,
wherein the second pole (R9_2) of the reference charge resistor (R9) is connected to the switch-on potential, the second electrode (C4_2) of the reference charge capacitor (C4) is connected to the switch-off potential and the anode of the comparator diode (D4) is connected to a control input (13) of the electronic switching unit (11).

5. Method for protecting a semiconductor switch (3) having a gate (5) which is controllable by a gate driver (7) by means of a protection circuit (9) according to claim 1 or by means of a circuit arrangement (1) according to one of claims 2 to 4, wherein
- a gate charge of the gate (5) is detected, and
- the semiconductor switch (3) is switched off dependent upon the value of the gate charge relative to a reference charge, wherein
- the reference charge is time-independent, and
- the semiconductor switch (3) is switched off if, after the elapsing of a minimum duration after a switching-on of the semiconductor switch (3), the gate charge falls below the reference charge.

## Revendications

1. Circuit (9) de protection d'un interrupteur (3) à semiconducteur ayant une grille (5) pouvant être commandée par une commande (7) de grille, le circuit (9) de protection comprenant
- un intégrateur (15) de détection d'une charge de la grille (5) par une tension (U3) de sortie d'intégrateur de l'intégrateur (15),
- une unité (19) de comparateur pour ouvrir l'interrupteur (3) à semiconducteur en fonction de la valeur de la charge de grille par rapport à une charge de référence et
- une temporisation (17) pour régler une durée minimum entre une fermeture de l'interrupteur (3) à semiconducteur et l'ouverture de l'interrupteur (3) à semiconducteur par l'unité (19) de comparateur,
- dans lequel la charge de référence est indépendante du temps et l'unité (19) de comparateur est constituée pour ouvrir l'interrupteur (3) à semiconducteur, lorsque la charge de grille passe en-dessous de la charge de référence,
- dans lequel la durée minimum est choisie, de manière à ce que pendant la durée minimum une capacité de grille et une capacité de Miller de l'interrupteur (3) à semiconducteur, après une fermeture dans un fonctionnement normal de l'interrupteur (3) à semiconducteur, sont rechargées au moins à peu près complètement, par exemple au moins à 90 %,
- **caractérisé en ce que** la temporisation (17) a une résistance (R1) de temporisation, un condensateur (C2) de temporisation et une diode (D2) de temporisation, l'anode de la diode (D2) de temporisation est connectée à un premier pôle (R1_1) de la résistance (R1) de temporisation et à une première électrode (C2-1) du condensateur (C2) de temporisation et une sortie de l'intégrateur (15) est connectée à la cathode d'une diode (D3) de sortie, dont l'anode est connectée à l'anode de la diode (D2) de temporisation, au premier pôle (R1_1) de la résistance (R1) de temporisation et à la première électrode (C2_1) du condensateur (C2) de temporisation, et
- dans lequel l'unité (19) de comparateur a un transistor (Q3) bipolaire npn, un transistor (Q4) bipolaire pnp, une première diode (D1) de comparateur, une deuxième diode (D4) de comparateur, un condensateur (C3) de comparateur, une première résistance (R8) de comparateur, une deuxième résistance (R6) de comparateur et une troisième résistance (R7) de comparateur, le collecteur du transistor (Q3) bipolaire npn est connecté à la base du transistor (Q4) bipolaire pnp, le collecteur du transistor (Q4) bipolaire pnp est connecté à la base du transistor (Q3) bipolaire npn et à l'anode de la première diode (D1) de compensateur, le condensateur (C3) de comparateur et la première résistance (R8) de comparateur sont montés respectivement en parallèle par rapport à la section base-émetteur du transistor (Q4) bipolaire pnp, la deuxième résistance (R6) de comparateur est montée en parallèle par rapport à la section base-émetteur du transistor du transistor (Q3) bipolaire npn, la cathode de la première diode (D1) de comparateur est connectée à l'anode de la diode (D3) de sortie, l'émetteur du transistor (Q3) bipolaire npn est connecté à la deuxième électrode (C2_2) du condensateur (C2) de temporisation, l'émetteur du transistor (Q4) bipolaire pnp est connecté, en passant par la troisième résistance (R7) de comparateur, au deuxième pôle (R1_2) de la résistance (R1) de temporisation et la base du transistor (Q4) bipolaire pnp est connectée à la cathode de la deuxième diode (D4) de comparateur.

2. Montage (1) de circuit, comprenant
- un interrupteur (3) à semiconducteur ayant une grille (5),
- une attaque (7) de grille pour commander la grille (5), dans lequel l'attaque (7) de grille a une unité (11) électronique de coupure, qui peut être commandée par une tension d'attaque de l'attaque (7) de grille et par laquelle la grille (5) est connectée, pour la fermeture de l'interrupteur (3) à semiconducteur, à un potentiel de fermeture et, pour l'ouverture de l'interrupteur (3) à semiconducteur, à un potentiel d'ouverture, et
- un circuit (9) de protection suivant la revendication **1.**

3. Montage (1) de circuit suivant la revendication 2, dans lequel l'émetteur du transistor (Q3) bipolaire npn est connecté au potentiel d'ouverture, le deuxième pôle (R1_2) de la résistance (R1) de temporisation est connecté au potentiel de fermeture et l'anode de la deuxième diode (D4) du comparateur est connectée à une entrée (13) de commande de l'unité (11) électronique de coupure.

4. Montage (1) de circuit suivant l'une des revendications 2 ou 3,
dans lequel le deuxième pôle (R9_2) de la résistance (R9) de charge de référence est connecté au potentiel de fermeture, la deuxième électrode (C4_2) du condenseur (C4) de charge de référence est connectée au potentiel d'ouverture et l'anode de la diode (D4) du comparateur est connectée à une entrée (13) de commande de l'unité (11) électronique de coupure.

5. Procédé de protection d'un interrupteur (3) à semiconducteur comprenant une grille (5) pouvant être commandée par une attaque (7) de grille au moyen d'un circuit (9) de protection suivant la revendication 1 ou au moyen d'un montage (1) de circuit suivant l'une des revendications 2 à 4, dans lequel
- on détecte une charge de la grille (5) et
- on ouvre l'interrupteur (3) à semiconducteur en fonction de la valeur de la charge de grille par rapport à une charge de référence, dans lequel
- la charge de référence est indépendante du temps et
- on ouvre l'interrupteur (3) à semiconducteur, si après l'écoulement d'une durée de temps minimum après la fermeture de l'interrupteur (3) à semiconducteur, la charge de grille passe en-dessous de la charge de référence.
